(19) Europäisches Patentamt
European Patent Office
Office européen des brevets

(11) **EP 4 390 349 B1**

(12) **EUROPEAN PATENT SPECIFICATION**

(45) Date of publication and mention
of the grant of the patent:
**29.10.2025 Bulletin 2025/44**

(21) Application number: **22306944.4**

(22) Date of filing: **19.12.2022**

(51) International Patent Classification (IPC):
**G01K 7/42** (2006.01)     **H02M 1/32** (2007.01)
**H02M 7/5387** (2007.01)

(52) Cooperative Patent Classification (CPC):
**G01K 7/427; H02M 1/327; H02M 7/53871;**
G01K 2217/00

(54) **THERMAL IMPEDANCE MONITORING PROCESS FOR POWER MODULES**

VERFAHREN ZUR ÜBERWACHUNG DER THERMISCHEN IMPEDANZ VON LEISTUNGSMODULEN

PROCÉDÉ DE SURVEILLANCE D'IMPÉDANCE THERMIQUE POUR MODULES DE PUISSANCE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**26.06.2024 Bulletin 2024/26**

(73) Proprietors:
• **Mitsubishi Electric R&D Centre Europe B.V.**
**1119 NS Schiphol Rijk Amsterdam (NL)**
Designated Contracting States:
**FR**
• **MITSUBISHI ELECTRIC CORPORATION**
**Chiyoda-ku**
**Tokyo 100-8310 (JP)**
Designated Contracting States:
**AL AT BE BG CH CY CZ DE DK EE ES FI GB GR HR HU IE IS IT LI LT LU LV MC ME MK MT NL NO PL PT RO RS SE SI SK SM TR**

(72) Inventors:
• **PICHON, Pierre-Yves**
**35708 RENNES CEDEX 7 (FR)**

• **BRANDELERO, Julio**
**35708 RENNES CEDEX 7 (FR)**

(74) Representative: **Plasseraud IP**
**104 Rue de Richelieu**
**CS92104**
**75080 Paris Cedex 02 (FR)**

(56) References cited:
**US-A1- 2022 034 958**

• **VAN DER BROECK CHRISTOPH H ET AL: "In-situ Thermal Impedance Spectroscopy of Power Electronic Modules for Localized Degradation Identification", PCIM EUROPE 2019, 7 May 2019 (2019-05-07), pages 1097 - 1104, XP093013165, Retrieved from the Internet <URL:https:// ieeexplore.ieee.org/stampPDF/getPDF.jsp?tp=& arnumber=8767631& ref=aHR0cHM6Ly9pZWVleHBsb3JlLmllZ WUub3JnL2RvY3VtZW50Lzg3Njc2MzE=>**

EP 4 390 349 B1

**Description**

**Field of the invention**

The present disclosure is in the field of protecting power semiconductor modules from failures due to overheating in particular overheating due to thermal interfaces degradation and maintenance of equipment using such modules.

**Background**

Thermal interfaces degradation in a power module is due to delamination and void creation in any of the substructures between a semiconductor die and a heatsink. These degradations increase temperature of the semiconductor die that can lead to an unsafe temperature operation region. The consequence of the high temperature is the semiconductor breakdown and power module failure. Monitoring the thermal interfaces is then important to maintain the power module in a safe temperature region and guide maintenance and replacement phases of the power module.

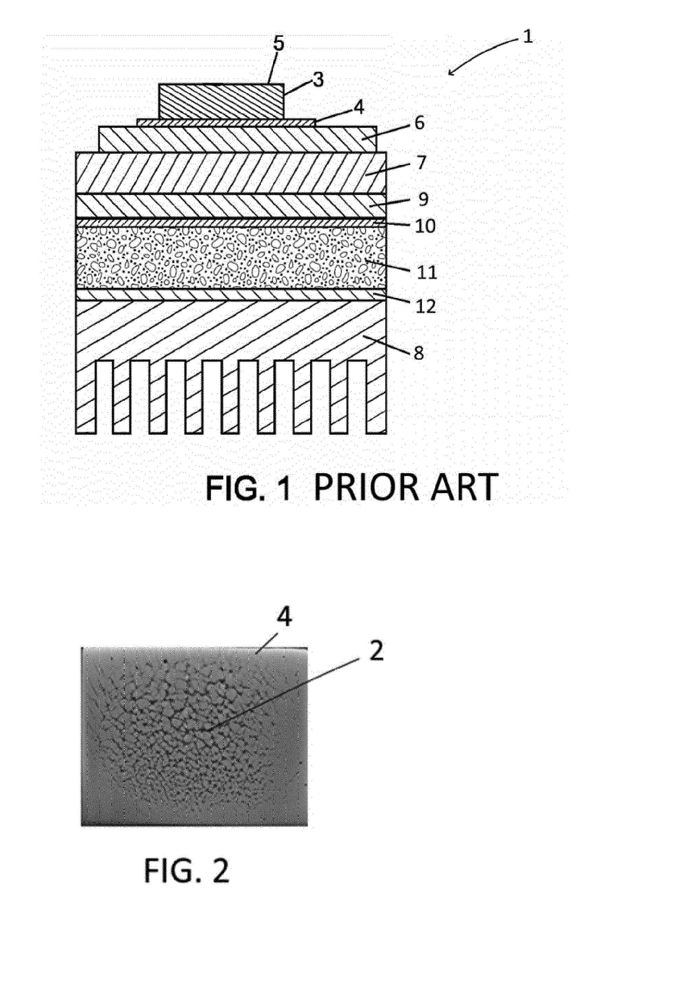

The degradation phenomena are caused by the temperature swing and the CTE mismatch between the different materials composing a power module stack-up shown in figure 1 that includes at least: semiconductor die 3 (for example in silicon), die attach 4 (for example in solder), a conductive layer 6 (for example in copper), an electrical insulator layer 7, and a heat-sink 8 (for example in aluminum).

The power module 1, can also comprise elements such : a thermal conductive layer 9 (for example in copper), a join layer 10 (for example solder), a base plate 11 (for example copper), a thermal interface 12 (for example graphite or thermal paste). A symmetric material stack-up can be also envisaged in the case of a double side cooling where the stack-up present hereinbefore is repeated on the top side 5 of the semiconductor die 3.

Figure 2 shows possible cracks 2 in a layer such as layer 4. Such cracks cause a reduction of the thermal conduction of the layer.

In document Broeck & al. "In situ thermal impedance spectroscopy of Power electronic modules for localized degradation identification", PCIM Europe 2019; International Exhibition and Conference for Power Electronics, Intelligent Motion, Renewable Energy and Energy Management, 07-09 May 2019 Nuremberg, Germany; VDE ISBN:978-3-8007-4938-6, is disclosed a method to extract the thermal impedance frequency response function of power modules without interrupting normal converter operations. A sinusoidal small-signal loss excitation to a power device, extracts the temperature response of such power device and correlates both signals to estimate the thermal impedance at the excitation frequency. The method relies on phase information rather than magnitude, and thus is insensitive to measurement errors in loss and/or temperatures. It requires a small signal loss excitation method that will impact on torque ripple for a motor driver application for example.

In document Polom & al., "Real-Time, In Situ Degradation Monitoring in Power Semiconductor Converters" 2019 IEEE Applied Power Electronics Conference and Exposition (APEC) , 17-21 March 2019, IEEE, DOI: 10.1109/APEC.2019.872182 the spatiotemporal dynamic thermal response of a semiconductor assembly response change with degradation is measured with a heat injection having a certain frequency content (sinus and square). The temperature of the semiconductor die is estimated via TSEP (thermal sensitive electrical parameter), the frequency response function (FRF) is computed for each system identification experiment, the FRF segments are combined and a function model is interpreted for thermal interface degradation.

In the document Xiang & al., "Condition Monitoring Power Module Solder Fatigue Using Inverter Harmonic Identification ", IEEE Transactions on Power Electronics, Volume: 27, Issue: 1, January 2012 Pages 235 - 247, DOI: 10.1109/TPEL.2011.2160988, a method to monitor solder fatigue in an inverter applying IGBT power module is described to detect the change of the output harmonic. It is shown that low-order harmonics, caused by nonideal switching, are affected by the device junction temperature, which in turn depends upon module solder condition. The method lacks on accuracy; thus, the inverter controller is set to cause harmonic resonance at a given frequency.

The standard JESD51-14 describe a method to measure the 'transient measurement of thermal resistance'. The method consists of measuring the junction temperature preferably after the heating power is switched off (cooling curve). Although not recommended, in principle also the heating curve can be used if there is a constant heating power during the heating pulse time. In the first case, the measurement obliges the power module to be turned-off after being worked in a known and thermal steady-state condition. In both cases, the power losses should be known, which is hardily estimated during the on-line operation (in field application).

Thermal impedance measurements techniques are powerful transient thermal response techniques which can give information on the degradation of the different interfaces of the power module. The technique typically consists in: First, applying a starting steady-state thermal condition on the power module using the semiconductor switch as active devices. This starting condition can either be a zero-power condition, or a condition where a known and measured constant power is dissipated at the semiconductor.

Second, applying a controlled power step increase (in case the start condition is a zero-power condition) or a power step decrease (in case the start condition is a constant power condition), and then recording the evolution of the semiconductor temperature until the new steady state thermal condition is reached.

Finally, the recorded temperature transient behavior is described by using an equivalent Foster and Cauer network which represent the thermal structure of the power module by several RC elements. A fitting of the temperature transient using the foster equation allow to extract the resistances and capacitances of the different part of the power module, giving information of the evolution of thermal resistances and capacitances.

Lock-in thermography techniques are well-proven commercially available techniques to detect material and system damages (e.g. delamination cracks in composites, voids, etc...) as discussed in Gerd Busse "Lockin-Thermography: Principles", NDE-applications and trends, January 2014 Conference: 2014 Quantitative InfraRed Thermography, DOI:10.21611/qirt.2014.e.

The lock-in thermography techniques uses a process where the material or system to be analyzed thermally is excited with a non-steady state signal (e.g a pulsed signal, or a sinusoidal signal) at a specific frequency (related to the material thickness or damage depth), for example using an infrared radiative source such as a set of halogen lamps, recording images of the transient temperature response of the system/material, using specific software and algorithm, calculating the phase and the amplitude between the response and the excitation, and thus generating a phase image and an amplitude image. These techniques are used in thermal steady state conditions.

Problems with respect to the state-of-the-art methods for thermal impedance monitoring are that:

- The dissipated power in the semiconductor must be known, i.e., it must be measured or estimated. In cases where the semiconductor is integrated in a power converter, this can be a difficult task;
- with the thermal measurement techniques described above, where the measurements are done in a steady state thermal situation) no information can be gained on which of the layers of the power module stack-up is degraded.

## Summary of the invention

The present disclosure proposes a measurement method using a lock-in technique in transient states instead of steady state situations.

More precisely, the present disclosure proposes a thermal impedance monitoring process for a power module of a power converter used for transforming DC current to AC current, or vice-versa, where the semiconductor dissipates an asymmetrical loss between two half cycles of an AC frequency f of the AC current, said power module comprising at least a semiconductor die attached to a material stack-up of layers for its thermal dissipation and/or electrical connections, said process comprising:

- sampling and measuring a signal relating to the junction temperature Tj of said semiconductor die at a frequency higher than ten time said AC frequency of said AC current,
- calculating a time duration $\Delta t = t_{Tjmax} - t_{Tjmin}$ between a moment $t_{Tjmax}$, where said junction temperature of said semiconductor die is at a maximum value, and a moment $t_{Tjmin}$, where said junction temperature is at a minimum value, in one period of said AC current, and storing said time duration $\Delta t$ in a memory,
- repeating said sampling and measuring said signal and said calculating said time duration at different times $t_x = t_0$ to $t_p$ during the operating life of the power module to provide a series of time durations $\Delta t_{t0}$ to $\Delta t_{tp}$, and comparing said time durations $\Delta t_{tp}$ values with $\Delta t_{t0}$ for monitoring an evolution of said time duration $\Delta t_x$ to determine an evolution of degradation of the thermal impedance of said power module.

The process may comprise measuring said AC frequency and storing couple of time duration $\Delta t_{tx}$ and AC frequency, $f_{fund}$ values.

The process may comprise modifying said AC frequency during dedicated operation periods of said converter to provide several different AC frequencies $f_m = f_1, f_2, ..., f_n$ each allowing to detect a thermal impedance of a specific layer of said stack up, repeating said sampling and measuring and said calculating the time durations $\Delta t_{txf1}, \Delta t_{txf2}, ... , \Delta t_{txfn}$ corresponding to such different AC frequencies,

- repeating said sampling and measuring said signal and said calculating said time duration during the operating life of the power module to provide a series of $\Delta t_0$ to $\Delta t_x$ values for each of said different AC frequencies, and comparing said $\Delta t_{txfm}$ values with $\Delta t_{t0fm}$ at each of said AC frequencies $f_m = f_1, f_2, ..., f_n$ for monitoring an evolution of $\Delta t_{xfm}$ for each of said AC frequencies to determine an evolution of degradation of the thermal impedance of said specific layers.

The process may comprise measuring a time difference $\Delta t_{min}$ between two successive minima of the junction temperature and calculating said AC frequency as $f = 1/\Delta t_{min}$.

The signal relating to the junction temperature Tj may be a temperature sensitive electrical parameter of said semiconductor.

In such case the signal may be a non-calibrated temperature sensitive electrical parameter of said semiconductor.

Said AC frequency may be lower than $f_d = \dfrac{D_{die}}{l_{die}^2}$ where $l_{die}$ is the die thickness and $D_{die}$ is the diffusivity coefficient of the die.

Said AC frequency may be lower than 2kHz.

Said AC frequency may be lower than 1kHz.

Said AC frequency may be the fundamental frequency powering the converter or the fundamental output frequency $f_{fund}$ of the converter.

The present disclosure concerns also a converter comprising sensor means on a power semiconductor switch die of said converter for sensing a temperature on said power semiconductor switch die, analog to digital converter means, sampling means and a processor provided with memory means for storing and running a software configured for executing the thermal impedance monitoring process described hereabove.In particular, said sensor means may be designed to sense a temperature sensitive electrical parameter of said die.The present disclosure proposes also a software comprising instructions for executing the thermal impedance monitoring process disclosed hereabove.

## Brief description of the drawings

A detailed description of exemplary embodiments of the disclosure will be discussed hereunder in reference to the attached drawings where:

Figure 1: is an example of traditional stack of layers for a power module;
Figure 2: is a view of a cracked solder layer;
Figure 3: is a prior art diagram of surface temperature response phase shift versus depth of a defect ;
Figure 4: is a Cauer network example of a stack-up of a power module
Figure 5: is a first Bode diagram for a first example of defects layers of a stack-up;
Figure 6: is a second Bode diagram for a second example of defects layers of a stack-up;
Figure 7: is a third Bode diagram for a third example of defects layers of a stack-up;
Figure 8: is an expanded Bode diagram for the first example of defects layers of the stack-up of figure 5;
Figure 9: is a simplified schematic view of a converter example with processor;
Figure 10A and 10B: are diagrams of losses and junction temperature versus time for a pristine and a degraded stack-up;
Figure 11: shows the losses waveforms for different modulation types in a DC/AC converter according to different controls;
Figure 12: shows a diagram of equivalent phase shift versus fundamental frequency for different degradations of layers;
Figures 13A, 13B, 13C : show process steps of the present process.

## Detailed description of embodiments

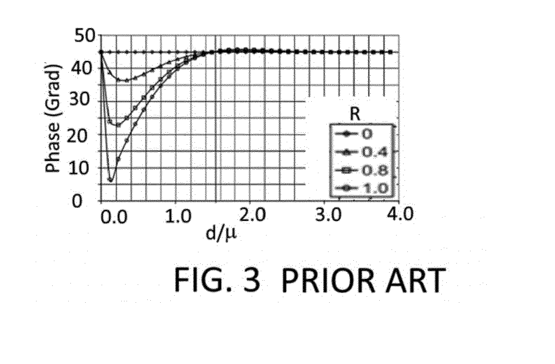

In order to characterize the behavior of a power module, the thermal wave theory predicts that the thermal response of the surface of a homogeneous infinite material half-space subjected to a thermal excitation $P_0 = P_0 (1 + \cos(\omega t))/2$ is shifted by $+\dfrac{\pi}{4}$ (+45°). Because of the wave nature of the excitation heat propagation within the material can be analyzed from wave theory,in which a defect or interface present at a distance d under the surface of the material can be modelled by a reflection coefficient R (0<R<1) for the thermal waves and will change the phase of thermal response of the surface, compared to the semi-infinite body case. The reflection coefficient is function of the material properties and of the contact resistance between the different materials, in case voids or defects are present at the interface. The reflection coefficient is also frequency dependent. The curves in figure 3 show the effect of a defect of strength R positioned a depth d on the phase shift of the surface temperature response as disclosed in document Rigert "Induktions-Lockin-Thermografie : ein neues Verfahren zur zerstörungsfreien Prüfung" http://dx.doi.org/10.18419/opus-1734. This chart shows the influence of the defect depth d (normalized with $\mu$, a material parameter), and the reflection coefficient R (R=0=> no defect (perfect transmission); R=1=> strong defect (perfect reflection)).

It can be seen that when a defect is positioned at d<1.55 $\mu$m and has a coefficient of reflection R>0.4, the surface temperature response phase shift changes from the semi-infinite body value of 45° to a lower value that depends on R and on the position of the defect.

Figure 3 thus shows the basic principle of lock-in thermography to characterize defects and interfaces in materials, devices including a module stack-up.

Importantly the value of $\mu$ is frequency dependent: for defects located further into the material, greater sensitivity is obtained when lower excitation frequency is used. Thus, by varying the excitation frequency, information about interface (degradation) of different layer stack or interface can be gained.

Although this simple model can give a good guidance on methods using thermal waves to detect damage, a power semiconductor stack cannot be modelled by a semi-infinite body, due to the different thermal properties of each layer of the stack. In order to analyze this system more precisely a 1D electrical equivalent of the thermal model can be used, one which the frequency response function can by analyzed.

Thermal impedance: electrical equivalent model:

On the basis that heat conduction and electronic conduction are both physical processes modelled by the same phenomenon (diffusion), the thermal impedance of a semiconductor module can be modelled by analogy with the scaled heat conduction equation and the telegrapher's equations. Thus, an equivalent electrical network of the thermal system can be deduced. The resistances and capacitances of the electrical equivalent are defined by analogy with a thermal resistance, Rth and capacitance Cth, using the following equations:

$$Rth = \frac{\Delta T}{\phi} = \frac{l}{\lambda \cdot A} \ (1)$$

Where 1 is the thickness;
A is the cross section area ;
$\lambda$ is the thermal conductivity,

$$Cth = \frac{Eth}{\Delta T} = c \cdot \rho \cdot V \ (2)$$

Where c is the specific heat capacity [J/g];
V is the volume [m3];
$\rho$ is the density [g/m3].

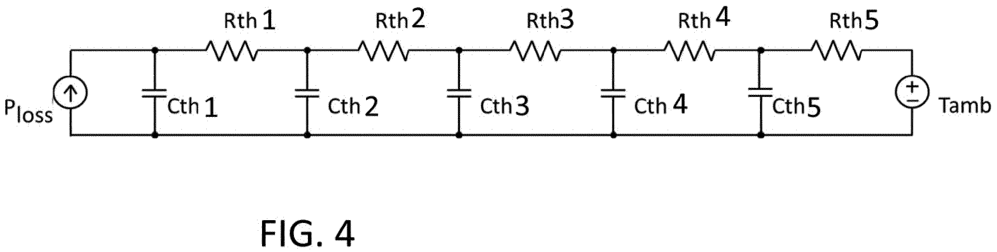

In the case of a simple model of power module composed with a stack-up of different materials, each layer will present a thermal resistance and a thermal capacitance. Thus, an electrical network, called Cauer network, can represent the thermal system of a stack-up of 5 layers as shown in Figure 4. $P_{loss}$ is the heat flux from the semiconductor die 5 of figure 1, corresponding to the losses dissipated on the semiconductor die (the electrical equivalent is a current source), $C_{th}$ and $R_{th}$ are the equivalent capacitance and resistance of each layer starting with the die layer 3 and the heatsink layer 5 and Tamb is the environment heatsink temperature.

The total thermal impedance of the network of figure 4 can be calculated using the following equation where s is the Laplacian operator:

$$Z(s) = \cfrac{1}{s \cdot Cth_1 + \cfrac{1}{Rth_1 + \cfrac{1}{s \cdot Cth_2 + \cfrac{1}{Rth_2 + \cfrac{1}{s \cdot Cth_3 + \cfrac{1}{Rth_3 + \cfrac{1}{s \cdot Cth_4 + \cfrac{1}{Rth_4 + \cfrac{1}{s \cdot Cth_5 + \cfrac{1}{Rth_5}}}}}}}}}$$

(3)

For the case of a degraded layer, a new (increased) resistance $R_{th,v}$ may be calculated using a percentage of void, f, as described in the next equation. As the material quantity is not modified, the thermal capacitance *Cth* remains unchanged:

$$R_{th,v} = \frac{Rth}{(1-f)^2} \quad (4)$$

For example, in the case of the stack-up of nine layers described in figure 1 and the material data of table 1 hereunder:

Table 1:

| Stack up layers | $\lambda$ W/mK | $\rho$ g/cm3 | c J/gK | l mm |
|---|---|---|---|---|
| 3 (silicon) | 80 | 2,3 | 0,712 | 0,14 |
| 4 (die attach) | 50 | 7,4 | 0,24 | 0,1 |
| 6 | 404 | 8,9 | 0,385 | 0,3 |
| 7 | 160 | 3,3 | 0,72 | 0,7 |
| 9 | 450 | 8,9 | 0,385 | 0,32 |
| 10 | 60 | 7,4 | 0,24 | 0,4 |
| 11 | 450 | 8,9 | 0,385 | 4 |
| 12 | 30 | 1,81 | 0,85 | 0,15 |
| 8 | 239 | 2,7 | 0,921 | 20 |

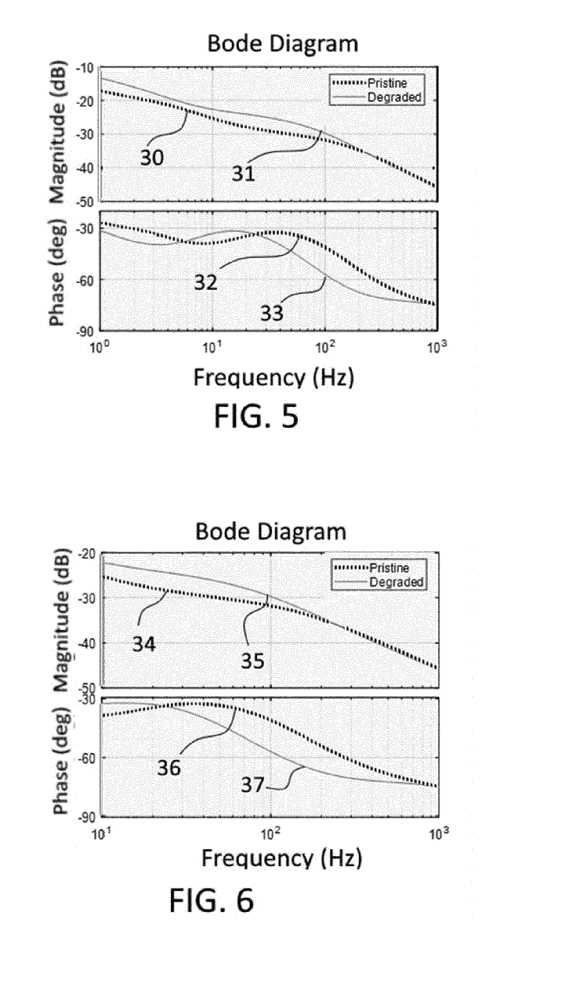

The thermal impedance may be plotted in a bode diagram, where the amplitude and the phase are plotted in function of the excitation frequency of a sinus type. In the curves of Figures 5 to 7 a comparison is done between a pristine, that is non-degraded module, and a degraded module according to figure 1 with measurements done at increasing frequencies.

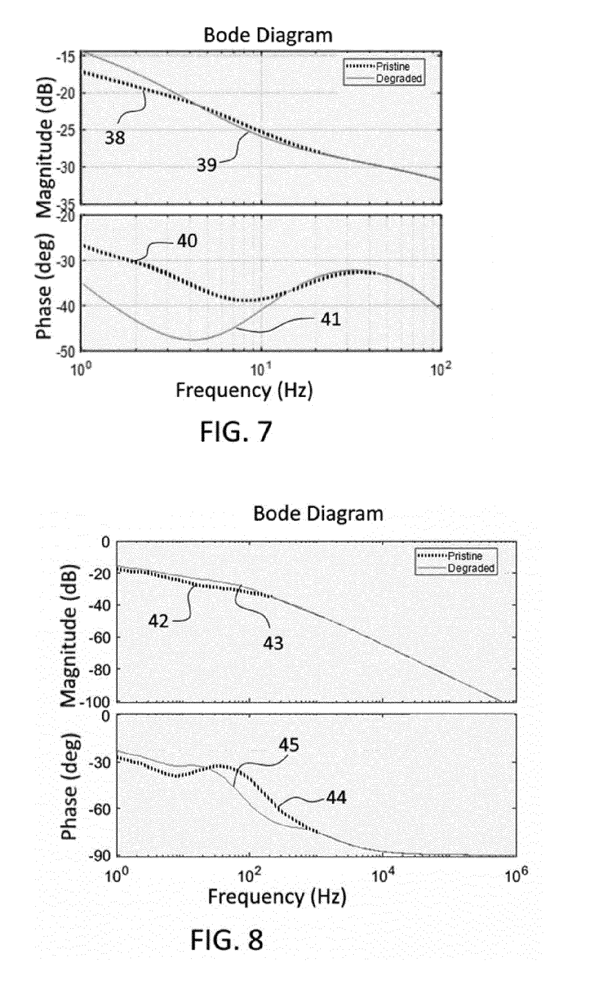

Figure 5 is the Bode diagram of a stack according to figure 1 with the layer 4 and the layer 10 having 40% of voids. Figure 6 is the Bode diagram of a stack according to figure 1 with the layer 4 has 40% of voids. Figure 7 is the Bode diagram of a stack according to figure 1 with the layer 10 has 40% of voids. These figures show that the amplitude and the phase of the thermal impedance are modified by the degradation.

Curves 32, 33 of figure 5, curves 36, 37 of figure 6 and curves 40, 41 of figure 7 are representing the phase difference between the temperature variations of the die for of pristine in dotted line and degraded layers in plain lines. Curves 30, 31 of figure 5, curves 34, 35 of figure 6 and curves 38, 39 of figure 7 are representing the amplitude of the temperature variation of the die with pristine in dotted line and degraded layers in plain lines.

the influence of a degradation of layer 4 which is located close to the excitation source can best be detected by a phase shift of curve 33 with respect to curve 32 at about 100Hz excitation as in figures 5 and 6, whereas a relatively lower excitation frequency from about 1 to 10Hz is required to detect a frequency shift between curve 40 and curve 41 corresponding to a damage in layer 10 which is located further away from the heat source as seen in figure 7. Note that no phase shift change is observed at 100Hz in case damage is introduced in layer 10. Thus, by varying the excitation frequency, it is possible to gain information on which layer is damaged.

Power semiconductors die losses:

The previous section described the thermal response of the system to a sinusoidal excitation. In real application cases the power dissipation does not necessarily follow a sinusoidal behavior. The goal of this section is to describe the necessary conditions of the semiconductor operating point that generate a suitable thermal response of the system such that an information on a layer degradation can be gained. To support the loss profile requirements, the bode diagram of figure 6 is plot on a larger frequency range as in figure 8 where the interval goes from 1Hz to 1 MHz.

In the present example, figure 8 shows the following information:

- The magnitude of the bode diagram gives essentially the same information as a thermal impedance plot;
- The phase information shows that the curves 42, 44 of non-degraded and the curves 44, 45 of degraded cases merge at f>1kHz. Thus, no information on the degradation can be gained by analysing the phase response of the system above this frequency.

The reason why the degraded and non-degraded cases cannot be separated at f>1KHz is because in the high frequency range the thermal impedance of the heat source (the silicon die) acts as a filter to the electrical excitation. This is straightforward when noticing that the thermal response timescale of the die is of order of $\tau_d = Rth_d \, Cth_d$. Using the definitions:

$$\tau_d = Rth_d \, Cth_d = \frac{l}{\lambda \cdot A} . c \cdot \rho \cdot V = \frac{l}{\lambda \cdot A} . c \cdot \rho \cdot A . l = \frac{l^2 c \cdot \rho}{\lambda} = \frac{l_d{}^2}{D_d} \, (5)$$

In diffusion theory $D = \frac{\lambda}{c \cdot \rho} \left(unit: \left[\frac{J.m^3 g.K}{s.m.K.g.J}\right] = \left[\frac{m^2}{s}\right]\right)$ is called the diffusivity coefficient. $\tau_d \approx \frac{l_d{}^2}{D_d}$ is the timescale needed for a heat pulse to travel through the die thickness $l_{die}$. Using the values of material 3 in table 1 we find $D_d = 4.88 \, 10^{-5} \frac{m^2}{s}$, using a die thickness $l_d = 0.14 \, mm$; $\tau_d = 4.01 \, 10^{-4}s$. The thermal system response bandwidth is thus limited by $f_d = \frac{1}{\tau_d} = 2.5 \, kHz$, which is the same order of magnitude as the 1kHz value found by examination of the bode diagram in figure 8.

The implication for the applicability of this invention is thus that the electrical excitation frequencies of interest should be significantly lower than $f_d = \frac{D_{si}}{l_d{}^2}$ ; i.e., preferably lower than 2kHz and preferably lower than 1kHz.

Advantageously to the present invention, typical signal modulation strategies such as PWM modulation in converters typically operate at frequencies higher than 1kHz, such as 5kHz, or 10kHz. In consequence, the thermal system response will be weak in this frequency range, and the temperature oscillations due to the PWM frequency will be weak as seen in the magnitude of the bode plot <-60dB of figure 8. Thus, advantageously, the thermal system will not be influenced by the PWM excitation. For the use of the model described in the previous section this justifies that the losses can be averaged over a PWM period.

Advantageously to the present invention, typical excitation frequencies may be limited by the load impedance, by the load requirements, or by the external control of the system, such that the system is typically excited in the frequency range of interest, i.e., at a frequency lower than 1kHz, for example 50Hz, 60Hz, 100Hz, 400Hz, or 1 Hz.

Another implication of this analysis is that a low frequency electrical excitation signal should not decrease from the maximum power value to the zero-power value within a time interval lower than $\tau_d$.

Thus, to summarize the power semiconductor losses requirements within the present invention: the power semiconductor die losses waveform is dependent on the application where the power module or system is installed.

This invention relates to the cases of DC/AC or AC/DC power converter topologies, and to the cases where the losses are low frequency periodic pulsating waves with the following characteristics:

a. A maximum pulse duration of a half-period of the fundamental frequency of the AC current, such that there exists a zero-loss time interval
AND
b. At least one local maximum inside the pulse, OR an asymmetrical loss dissipation between the two half-cycles.
AND
c. The time difference between the last maximum and the zero-loss time is larger than $\tau_d = \frac{l_d{}^2}{D_d}$, where $l_d$ is the thickness of the semiconductor chip, and $D_d$ is the heat diffusivity of the semiconductor chip. This implies the low frequency of the modulated losses to be lower than $f_d = \frac{D_{die}}{l_{die}{}^2}$ where $l_{die}$ is the die thickness and $D_{die}$ is the diffusivity coefficient of the die.

As an example, for condition c, the semiconductor chip is a silicon chip of thickness $l_{die} =100\mu m$, the thermal diffusivity coefficient of silicon is $D_{die} =4.89 \, 10^{-4} \, m^2/s$, and thus $f_{die} = 4.89kHz$, and $\tau_{die} =205\mu s$.

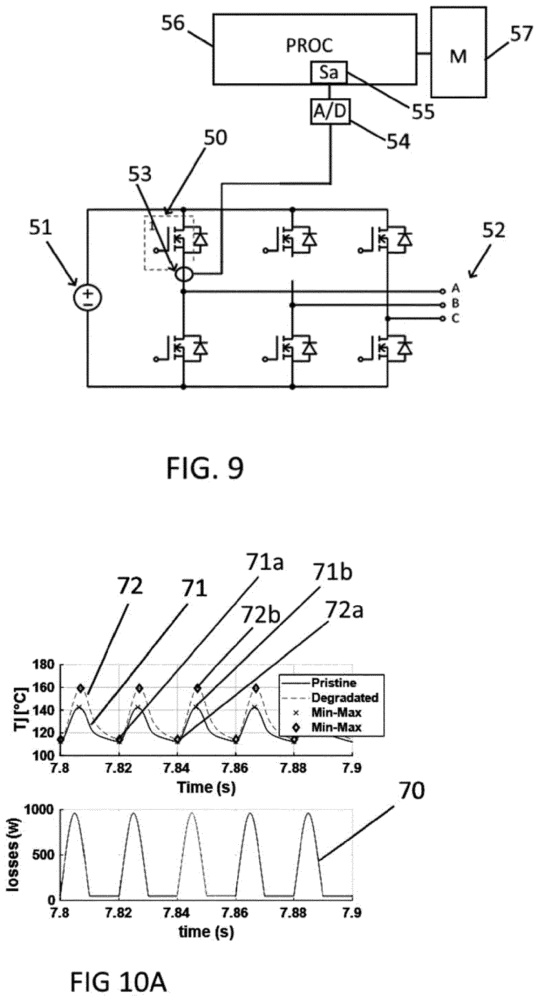

An example of DC/AC power topology is shown in figure 9 where a DC supply 51 serves to build a three-phase alternating supply 52 using power semiconductor switches 1. The DC/AC power converter has a 3-phase configuration supplied by a DC bus voltage. The semiconductor die can be any IGBT, Diode, MOSFET, MISFET and in any placement of the power converter topology. In the following example, the semiconductor die of interest in the power module is placed in one leg at the high side position.

The switching and conduction losses of the semiconductor die 50 are generated in a normal operation of the power module in a motor control application given the load current, the bus voltage during the switching and conduction events.

The semiconductor die losses generation in a power module on a DC/AC or DC/AC operation is proportional to the following variables that are related to the operating point: the current passing through $I_{cond}$, the switched current $I_{sw}$, the switched voltage $V_{sw}$, the switching frequency $f_{sw}$, the junction temperature, $T_j$, the duty cycle modulation strategy / PWM technique.

In such an application, typically, a periodic pulsed loss waveform in an DC/AC or AC/DC application is generated in the fundamental frequency, e.g., a grid frequency 50Hz or an electrical motor rotation control frequency of 1Hz - 2kHz. In any strategy, the losses on the semiconductor are generated only during a time corresponding to a first half-cycle of the fundamental frequency, and the semiconductor does not generate any losses during the second half cycle of the fundamental frequency.

Considering that the power converter generates a sinusoidal current waveform, at the fundamental frequency of 100Hz, on the output of the phases ABC and a chopped voltage waveform at the switching frequency operation of 20kHz.

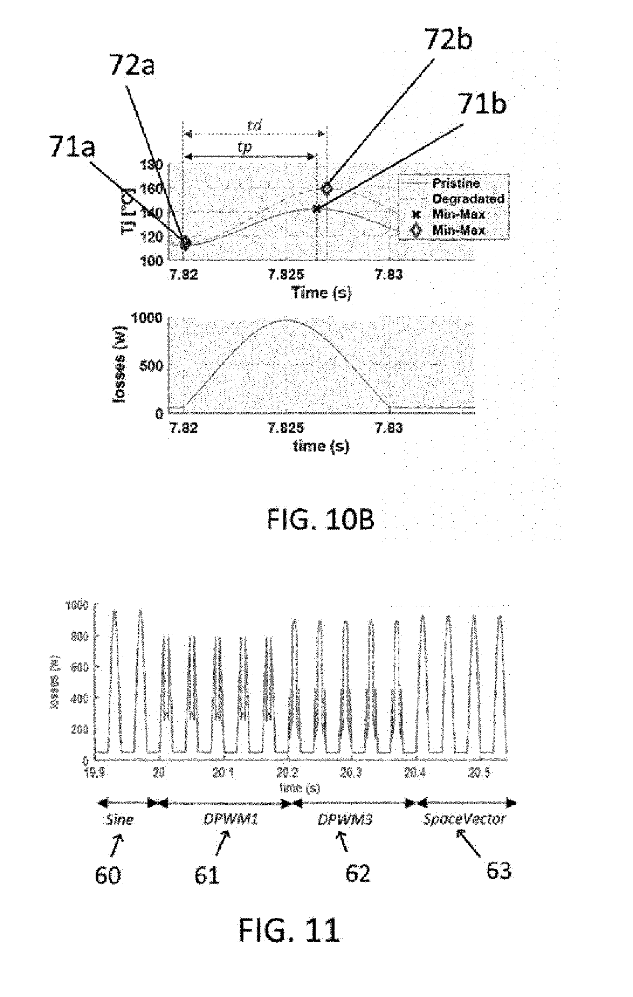

Figures 10A and 10B are representation of the junction temperature and losses for a pristine and degraded power module at 100Hz of fundamental AC frequency. Figure 10A is a general view of the power and junction temperature waves with respect to time, Figure 10B is a zoomed figure on one loss period comprising also a measurement of the die temperature Tj duration time. In this example, the losses wave 70 in figure 10A on the semiconductor die has only the positive sinusoidal shape. In other words, the losses follow a sinusoidal shape between 0° and 180° (0 and $\pi$) and have a null value between 180° and 360° ($\pi$ and $2\pi$) within the fundamental frequency $f_f$.

$$Ploss \approx \begin{cases} A \cdot sin^2(2\pi \cdot f_f \cdot t) & for & 0 \leq 2\pi \cdot f_f \cdot t \leq \pi \\ 0 & for & \pi < 2\pi \cdot f_f \cdot t < 2\pi \end{cases} \quad (6)$$

The temperature response Tj of the die 71, 72 in figure 10A is calculated using the thermal impedance. The temperature wave has one minimum 71a, 72a and one maximum 71b, 72b within a fundamental period. When measuring the time between the minimum temperature point and the maximum temperature point gives an indicator of the module degradation. In figure 10B showing a single loss period, it can be seen that the degraded power module with 40% of voids in layer 4 of figure 1 operating at 100Hz of AC current has a longer duration time $\Delta t=td$ than that of the pristine power module $\Delta t=tp$. This can be explained by the bode diagram of figure 6, showing a larger absolute phase angle for the degraded thermal impedance compared to the pristine thermal impedance at 100Hz.

An important point is that it is possible only by examination of the temperature response to identify the beginning of the pulse corresponding to tTjmin, because the sudden power change generates a kink in the temperature response. Thus, advantageously, the information of $\Delta t=tTjmax-tTjmin$ is related to the phase angle between the temperature response and the power excitation.

Figure 11 shows the losses in the fundamental frequency of the converter plotted for different modulation strategies when a DC/AC power converter drives an electrical motor. The different modulation strategies are: Sine 60, DPWM1 61, DPWM3 62, Spacevector 63. The losses are calculated considering both the conduction losses and the switching losses of the semiconductor die, and averaged over a modulation period.

The topologies of the converter are not limited to the converter taken as an example but could be multilevel topologies as the NPC (neutral point clamped inverter), ANPC (Active-neutral-point-clamped inverter), MMC (modular multilevel converter), FC (flying capacitor) and other topologies that are the state of art.

This shows that in an AC/DC or DC/AC power converter having a power module comprising at least a semiconductor die attached to a material stack-up for the thermal dissipation and/or for electrical connections, where the semiconductor dissipates an asymmetrical loss between two half cycles of the AC frequency, measuring a signal related to the temperature of the semiconductor at said frequency, measuring the time duration $\Delta t=tTjmax-tTjmin$ between the temperatures Tjmax and Tjmin where the junction temperature is at the maximum and respectively its minimum value, in an AC period permits to obtain a measurement of the degradation of at least one layer in a stack of layers between the die and a heatsink to which the die is attached by repeating such measurements during life of the power converter.

Thus, advantageously since de degradation is sensitive to the temperature increase time delay $\Delta t$, and not to the magnitude of the temperature, nor the magnitude of the power losses the thermal degradation estimation is not sensitive to the accuracy of the junction temperature measurement, and thus any signal related to the temperature of the semiconductor can be used, provided there is a monotonous relation between the temperature and the signal. It is not necessary to estimate or measure the power losses in the semiconductor, thus advantageously reducing the number of sensors, the computation time and increasing the accuracy of the degradation measurement.

In order to repeat measurements and compare such during the life of the converter, the calculations of the temperature increase time delay $\Delta t= tTjmax- tTjmin$ may be stored in a memory at each iteration and compared with an initial value and/or a previous value and the evolution of such time delay $\Delta t_x$ for $t_x=t_0$ to $t_p$ may be monitored to obtain the degradation state of the thermal impedance.

In addition to the measurement of the temperature increase time delay, the fundamental frequency $f_{fund}$ at which the losses are measured may be measured and stored and the degradation state is determined by the time duration $\Delta t(f_{fund})$ at said fundamental frequency.

Thus, advantageously, degradation information of a specific stack layer can be gained, as the variation of the damage indicator $\Delta t_x$ is sensitive to the fundamental frequency.

For example, the fundamental loss frequency can be measured using the AC load current probe, or be given by the controller reference, or be given by the user AC frequency request.

As discussed hereunder, damages at different height in the stack cause different phase shift in the temperature increase curves and measuring damage indicators $\Delta ti(f_{fund,i})$ at different frequencies $f_{fund,i}$ enables to gain information on the degradation evolution at different layers of the stack. The higher frequencies are used to monitor a degradation of the stack layers closer to the semiconductor and the lower frequencies are used to monitor a degradation of the stack layers farther from the semiconductor.

The effect of the degradation on the frequency response functions for a specific layer of the stack can be determined by introducing a degradation in a specific layer, for example using equation 4, measuring the phase shift associated with this degradation using the Z(s) estimation of equation 3, and plotting a bode diagram as in figures 5 to 7.

As an example, one or several frequencies between 20Hz to 500Hz are used to monitor the degradation on the layer 4 according to Figure 6 and one or several frequencies between 1Hz to 10Hz are used to monitor the layer 10 resulting in the curve of figure 7.

In the case of a combination of several degradations, monitoring of the time delay at several frequencies enables to separate the contributions of the several degradations as in the example of figure 5.

To support the relation between $\Delta t$ and the phase angle, as a first approximation, the change of phase angle *Ph* in angular unit of degrees (°) due to the degradation, that is the change from $\Delta t=tp$ to $\Delta t=td$ can be approximated by the following equation:

$$Ph = (td - tp) \cdot f_f \cdot 360 \qquad (7)$$

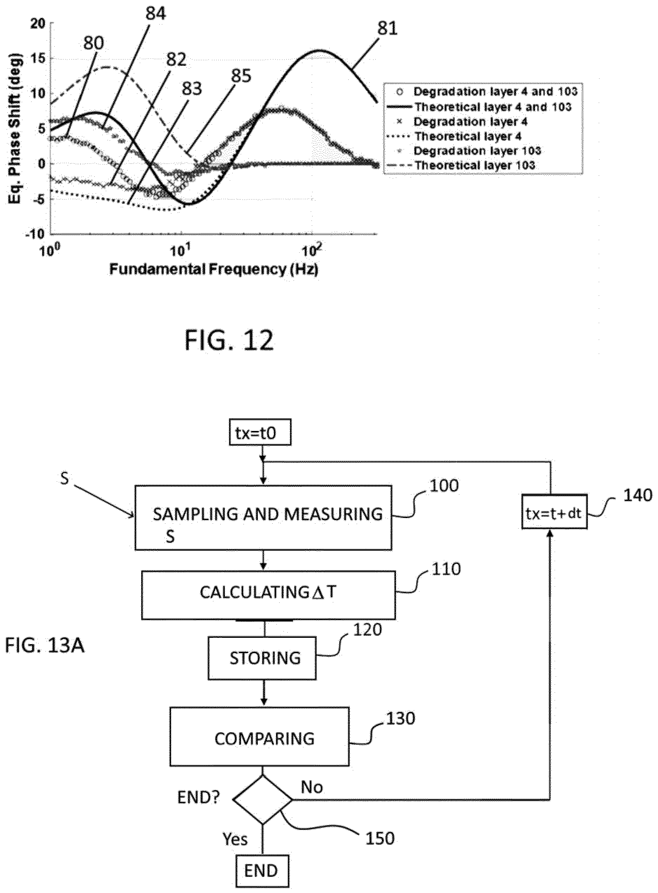

Figure 12 shows a comparison of first-order estimation of the phase Ph using equation (8), and the phase extracted from calculations using the impedance method with respect to the fundamental frequency. In this diagram, curve 80 is the estimated phase curve for degraded layers 4 and 10 of figure 1 while curve 81 is the theoretical curve for such degraded layers, curve 82 is the estimated phase curve for degraded layer 4 while curve 83 is the theoretical curve fir such degraded layer, curve 84 is the estimated phase curve for degrade layer 10 and curve 85 the theoretical curve for such degraded layer 10. This shows that for frequencies above around 10 Hz, the first order estimation shows similar trend as the more rigorous model, thus demonstrating that the information in $\Delta t$ is the same as in the phase of the bode diagrams of figures 5 to 8.

Then, in case the fundamental frequency f of the AC current may be changed, the process may monitor the time difference for different fundamental frequencies. This gives a possibility to provide estimation of which of the layers are degraded layers.

As the time difference $\Delta tmin$ between two successive minima of the junction temperature is measured, the fundamental frequency may be calculated as $f_{fund}= 1/\Delta tmin$

Thus, advantageously, this allows to record the fundamental frequency without using an additional sensor, or without acquiring the fundamental frequency information from a separate algorithm. Thus, advantageously, the algorithm for degradation analysis can work independently of a control algorithm of the converter or any other operating condition of the power module.

In example, in figure 10A, the time interval between two successive minima is $\Delta tmin =0.02s$, and thus the fundamental frequency is found as $f_{fund}=1/\Delta tmin=50Hz$.

The signal used for measuring the temperature may be any thermal sensitive electrical parameter (TSEP) of the concerned semiconductor switch.

Thus, the deterioration can be identified and quantified without any complex prior TSEP calibration, reducing the complexity of the system.

For example, the TSEP can have values X between Xa and Xb corresponding, for example to the range of temperature [-20C;200C], and the relation between the temperature and the TSEP is linear such as:

T=XA+B in [Xa;Xb] where A and B are constant

In this example, it is not necessary to calibrate the TSEP, i.e., to determine A and B before implementing the method since only the variable X is measured. In a sub example, A>0, and the moments tTjmax and tTjmin where the junction temperature is at the maximum correspond to the moments where X is at the maximum, respectively at the minimum value. In another sub example, A<0, and the moments tTjmax and tTjmin where the junction temperature is at the maximum correspond to the moments where X is at the minimum, respectively at the maximum value.

More generally, it is sufficient that the function T(X) is monotonously increasing or decreasing, e.g., that its first derivative does not change sign in the interval [Xa;Xb]. Thus, advantageously non-calibrated TSEP with a non-linear temperature characteristic can also be used in the scope of the present disclosure.

In figure 13A are shown process steps of the present disclosure with the process comprising:

- Step 100: sampling and measuring a signal S relating to the junction temperature Tj of said semiconductor die at a frequency higher than ten time said AC frequency of said AC current 100,
- Step 110 calculating a time duration $\Delta t$= tTjmax- tTjmin between a moment tTjmax, where said junction temperature of said semiconductor die is at a maximum value, and a moment tTjmin, where said junction temperature is at a minimum value, in one period of said AC current, and step 120 storing said time duration $\Delta t$ in a memory,
- step 130 comparing said time durations $\Delta t_{t0}$ to $\Delta t_{tp}$ for t=$t_0$ to $t_p$ values for monitoring an evolution of said time duration $\Delta t$ to determine an evolution of degradation of the thermal impedance of said power module;
- repeating 140, 150 said sampling and measuring said signal and said calculating said time duration at different times tx=$t_0$ to $t_p$ during the operating life of the power module to provide a series of time durations $\Delta t_{t0}$ to $\Delta t_{tp}$.

Step 100 may also comprise measuring said AC frequency and step 120 may comprise storing couple of time duration $\Delta t_{tx}$ and AC frequency, $f_{fund}$ values.

Measuring in step 100 may be done with several means such as thermocouple, infrared image, TSEP etc.

Since there may be some noise in the measurements, averaging of the $\Delta t$ values may be required and the comparison may not be done strictly with the first $\Delta t_0$ value measured, but rather with a mean value over a measurement period of a few alternances at the beginning of the product usage. In such case, the averaging may be done on about two to ten alternances.

Repetition of the sampling, measuring and the comparison maybe done on a regular basis that is every day, week, month or after a number of alternances of the AC frequency corresponding to the use of the converter (e.g., tenth or hundreds of hours) relevant with the estimated degradation rate. Repetition rate may also be accelerated when a difference between $\Delta t_{tx}$ and $\Delta t_0$ becomes larger than a predetermined warning value.

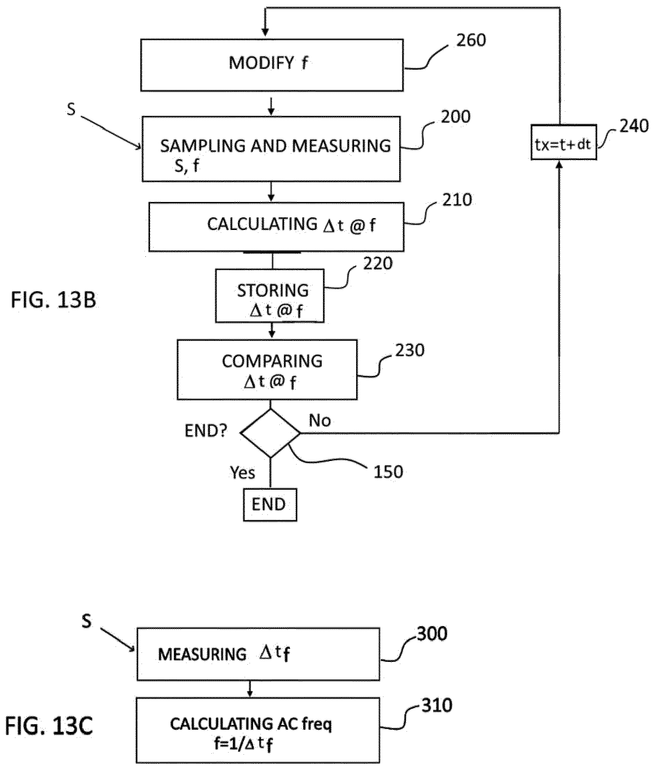

The process may also comprise as shown in figure 13B one or more steps 260 of modifying said AC frequency during dedicated operation periods of said converter to provide several different AC frequencies $f_m$= $f_1$, $f_2$, ..., $f_n$ each allowing to detect a thermal impedance of a specific layer of said stack up, repeating said sampling, and measuring the TSEP signal S and the frequency 200 and said calculating 210 the time durations $\Delta t_{txf1}$, $\Delta t_{txf2}$, ... , $\Delta t_{txfn}$ corresponding to such different AC frequencies,

- one or more steps 230 of comparing said $\Delta t_{t0fm}$ to $\Delta t_{tpfm}$ values at each of said AC frequencies for monitoring an evolution of $\Delta t$ for each of said AC frequencies to determine an evolution of degradation of the thermal impedance of said specific layers,
- repeating said sampling and measuring said signal and said calculating said time duration during the operating life of the power module to provide a series of $\Delta t_{x=}$ $\Delta t_0$ to $\Delta t_p$ values for each of said different AC frequencies $f_m$ for comparing the $\Delta t_x$ values with the $\Delta t_0$ value.

Here also, repetition of the sampling, measuring and the comparison maybe done on a regular basis that is every day, week, month or after a number of alternances of the AC frequency corresponding to the use of the converter (e.g., tenth or hundreds of hours) relevant with the estimated degradation rate. Repetition rate may also be accelerated when a difference between $\Delta t_{tx}$ and $\Delta t_0$ becomes larger than a predetermined warning value.

In addition, the tests using adaptation of the AC freqeuncy may be done in specific situations such as tests on the grid frequency or ramping of a motor speed.

The process also may comprise as in figure 13C one or more steps 300 of measuring a time difference $\Delta$tmin between two successive minima of the junction temperature and calculating 310 said AC frequency as f=1/$\Delta$tmin. This avoids having to measure the frequency with another means than the signal S relating to the junction temperature Tj which may be a non-calibrated temperature sensitive electrical parameter of said semiconductor.

To proceed with the present process the converter as shown in figure 9 may comprise sensor means 53 on a power semiconductor switch die of said converter for sensing a TSEP signal of said power semiconductor switch die, analog to digital converter means 54, sampling means 55 and a processor 56 provided with the necessary memory means 57 and computing means for storing and running a software configured for executing the thermal impedance monitoring process of the present disclosure.

## Claims

1. - Thermal impedance monitoring process for a power module of a power converter used for transforming DC current to AC current, or vice-versa, where the semiconductor dissipates an asymmetrical loss between two half cycles of an AC frequency f of the AC current, said power module comprising at least a semiconductor die (50) attached to a material stack-up of layers for its thermal dissipation and/or electrical connections, the thermal impedance monitoring process being **characterised by** the following steps:

- sampling and measuring (100) a signal relating to the junction temperature Tj of said semiconductor die at a frequency higher than ten time said AC frequency of said AC current,
- calculating (110) a time duration $\Delta t = tTjmax - tTjmin$ between a moment tTjmax, where said junction temperature of said semiconductor die is at a maximum value, and a moment tTjmin, where said junction temperature is at a minimum value, in one period of said AC current, and storing (120) said time duration $\Delta t$ in a memory,
- repeating (140, 150) said sampling and measuring said signal and said calculating said time duration at different times $t_x = t_0$ to $t_p$ during the operating life of the power module to provide a series of time durations $\Delta t_{t0}$ to $\Delta t_{tp}$, and comparing (130) said time durations $\Delta t_{tp}$ values with $\Delta t_{t0}$ for monitoring an evolution of said time duration $\Delta t_x$ to determine an evolution of degradation of the thermal impedance of said power module.

2. - Thermal impedance monitoring process according to claim 1 comprising averaging the $\Delta t$ measurements on periods for reducing noise in the measurements.

3. - Thermal impedance monitoring process according to claim 1 or 2 comprising measuring said AC frequency (200) and storing couple of time duration $\Delta t_{tx}$ and AC frequency, $f_{fund}$ values (220).

4. - Thermal impedance monitoring process according to claim 3 comprising modifying said AC frequency (260) during dedicated operation periods of said converter to provide several different AC frequencies $f_m = f_1, f_2, ..., f_n$ each allowing to detect a thermal impedance of a specific layer of said stack up, repeating said sampling, and measuring and said calculating the time durations $\Delta t_{txfm} = \Delta t_{txf1}, \Delta t_{txf2}, ... , \Delta t_{txfn}$ corresponding to such different AC frequencies,

- repeating (240) said sampling and measuring said signal and said calculating said time duration during the operating life of the power module to provide a series of $\Delta t_{0fm}$ to $\Delta t_{xfm}$ values for each of said different AC frequencies, and comparing said $\Delta t_{tm}$ values with $\Delta t_{t0}$ at each of said AC frequencies for monitoring an evolution of $\Delta t$ for each of said AC frequencies $f_m = f_1, f_2, ..., f_n$ to determine an evolution of degradation of the thermal impedance of said specific layers.

5. - Thermal impedance monitoring process according to claim 3 or 4 comprising measuring (300) a time difference $\Delta tmin$ between two successive minima of the junction temperature and calculating said AC frequency as $f = 1/\Delta tmin$.

6. - Thermal impedance monitoring process according to any one of the preceding claims wherein the signal relating to the junction temperature Tj is a temperature sensitive electrical parameter of said semiconductor.

7. - Thermal impedance monitoring process according to claim 6 wherein the signal relating to the junction temperature Tj is a non-calibrated temperature sensitive electrical parameter of said semiconductor.

8. - Thermal impedance monitoring process according to any one of the preceding claims wherein said AC frequency is lower than $f_d = \dfrac{D_{die}}{l_{die}^2}$ where $l_{die}$ is the die thickness and $D_{die}$ is the diffusivity coefficient of the die.

9. - Thermal impedance monitoring process according to any one of the preceding claims wherein said AC frequency is lower than 2kHz.

10. - Thermal impedance monitoring process according to any one of the preceding claims wherein said AC frequency is lower than 1kHz.

11. - Thermal impedance monitoring process according to any one of the preceding claims wherein said AC frequency is the fundamental frequency powering the converter or the fundamental output frequency $f_{fund}$ of the converter.

12. - Converter comprising sensor means (53) on a power semiconductor switch die of said converter for sensing a temperature of said power semiconductor switch die, analog to digital converter means (54), sampling means (55) and a processor (56) provided with memory means (57) for storing and running a software configured for causing the converter to execute the thermal impedance monitoring process according to any one of the preceding claims.

**13.** - Converter according to claim 12 wherein said sensor means (53) are designed to sense a temperature sensitive electrical parameter of said power semiconductor switch die.

**14.** - Permanent memory means comprising a software comprising instructions for executing the thermal impedance monitoring process according to any one of claim 1 to 11 when executed by the converter according to claim 12.

**Patentansprüche**

**1.** Prozess zur Überwachung einer thermischen Impedanz für ein Leistungsmodul eines Leistungswandlers, welcher zum Umwandeln von Gleichstrom in Wechselstrom oder umgekehrt verwendet wird, wobei der Halbleiter zwischen zwei Halbzyklen einer Wechselstromfrequenz f des Wechselstroms einen asymmetrischen Verlust ableitet, wobei das Leistungsmodul wenigstens einen Halbleiter-Chip (50) umfasst, welcher für seine Wärmeableitung und/oder elektrischen Verbindungen an einem aus Schichten aufgestapelten Material angebracht ist, wobei der Prozess zur Überwachung einer thermischen Impedanz durch die folgenden Schritte gekennzeichnet ist:

- Abtasten und Messen (100) eines Signals in Bezug auf die Sperrschichttemperatur Tj des Halbleiter-Chips bei einer Frequenz, welche höher als zehn Mal die Wechselstromfrequenz des Wechselstroms ist,
- Berechnen (110) einer Zeitdauer $\Delta t = tTjmax - tTjmin$ zwischen einem Moment tTjmax, in welchem die Sperrschichttemperatur des Halbleiter-Chips bei einem maximalen Wert liegt, und einem Moment tTjmin, in welchem die Sperrschichttemperatur bei einem minimalen Wert liegt, in einer Periode des Wechselstroms und Speichern (120) der Zeitdauer $\Delta t$ in einem Speicher,
- Wiederholen (140, 150) des Abtastens und Messens des Signals und des Berechnens der Zeitdauer zu verschiedenen Zeiten $t_x = t_0$ bis $t_p$ während der Lebensdauer des Leistungsmoduls, um eine Reihe von Zeitdauern $\Delta t_{t0}$ bis $\Delta t_{tp}$ bereitzustellen, und Vergleichen (130) der Werte der Zeitdauern $\Delta t_{tp}$ mit $\Delta t_{t0}$ zum Überwachen einer Entwicklung der Zeitdauer $\Delta t_x$, um eine Entwicklung einer Verschlechterung der thermischen Impedanz des Leistungsmoduls zu bestimmen.

**2.** Prozess zur Überwachung einer thermischen Impedanz nach Anspruch 1, umfassend ein Mitteln der $\Delta t$-Messungen über Zeiträume zum Reduzieren eines Rauschens in den Messungen.

**3.** Prozess zur Überwachung einer thermischen Impedanz nach Anspruch 1 oder 2, umfassend ein Messen der Wechselstromfrequenz (200) und ein Speichern des Paars der Werte der Zeitdauer $\Delta t_{tx}$ und der Wechselstromfrequenz $f_{fund}$ (220).

**4.** Prozess zur Überwachung einer thermischen Impedanz nach Anspruch 3, umfassend ein Modifizieren der Wechselstromfrequenz (260) während dedizierter Betriebsperioden des Wandlers, um mehrere verschiedene Wechselstromfrequenzen $f_m = f_1, f_2, ..., f_n$ bereitzustellen, welche es jeweils ermöglichen, eine thermische Impedanz einer spezifischen Schicht des Stapels zu detektieren, ein Wiederholen des Abtastens und Messens und des Berechnens der solchen verschiedenen Wechselstromfrequenzen entsprechenden Zeitdauern $\Delta tt_{xfm} = \Delta t_{xf1}, \Delta t_{xf2}, ..., \Delta t_{xfn}$,

- Wiederholen (240) des Abtastens und Messens des Signals und des Berechnens der Zeitdauer während der Lebensdauer des Leistungsmoduls, um für jede der verschiedenen Wechselstromfrequenzen eine Reihe von Werten $\Delta t_{0fm}$ bis $\Delta f_{xfm}$ bereitzustellen, und Vergleichen der Werte $\Delta t_{tm}$ mit $\Delta t_0$ bei jeder der Wechselstromfrequenzen zum Überwachen einer Entwicklung von $\Delta t$ für jede der Wechselstromfrequenzen $f_m = f_1, f_2, ..., f_n$, um eine Entwicklung einer Verschlechterung der thermischen Impedanz der spezifischen Schichten zu bestimmen.

**5.** Prozess zur Überwachung einer thermischen Impedanz nach Anspruch 3 oder 4, umfassend ein Messen (300) einer Zeitdifferenz $\Delta tmin$ zwischen zwei aufeinanderfolgenden Minima der Sperrschichttemperatur und ein Berechnen der Wechselstromfrequenz als $f = 1/\Delta tmin$.

**6.** Prozess zur Überwachung einer thermischen Impedanz nach einem der vorhergehenden Ansprüche, wobei das Signal in Bezug auf die Sperrschichttemperatur Tj ein temperaturempfindlicher elektrischer Parameter des Halbleiters ist.

**7.** Prozess zur Überwachung einer thermischen Impedanz nach Anspruch 6, wobei das Signal in Bezug auf die Sperrschichttemperatur Tj ein nicht kalibrierter temperaturempfindlicher elektrischer Parameter des Halbleiters ist.

8. Prozess zur Überwachung einer thermischen Impedanz nach einem der vorhergehenden Ansprüche, wobei die Wechselstromfrequenz niedriger ist als $f_d = \frac{D_d}{l_d^2}$, wobei $l_{die}$ die Dicke und $D_{die}$ der Diffusionskoeffizient des Chips ist.

9. Prozess zur Überwachung einer thermischen Impedanz nach einem der vorhergehenden Ansprüche, wobei die Wechselstromfrequenz niedriger ist als 2 kHz.

10. Prozess zur Überwachung einer thermischen Impedanz nach einem der vorhergehenden Ansprüche, wobei die Wechselstromfrequenz niedriger ist als 1 kHz.

11. Prozess zur Überwachung einer thermischen Impedanz nach einem der vorhergehenden Ansprüche, wobei die Wechselstromfrequenz die Grundfrequenz, welche den Wandler antreibt, oder die Grundausgangsfrequenz $f_{fund}$ des Wandlers ist.

12. Wandler, umfassend Sensormittel (53) an einem Leistungshalbleiterschalter-Chip des Wandlers zum Erfassen einer Temperatur des Leistungshalbleiterschalter-Chips, Analog-Digital-Wandler-Mittel (54), Abtastmittel (55) und einen Prozessor (56), welcher mit Speichermitteln (57) zum Speichern und Ausführen einer Software bereitgestellt ist, welche dazu eingerichtet ist, zu veranlassen, dass der Wandler den Prozess zur Überwachung einer thermischen Impedanz nach einem der vorhergehenden Ansprüche ausführt.

13. Wandler nach Anspruch 12, wobei die Sensormittel (53) ausgelegt sind, um einen temperaturempfindlichen elektrischen Parameter des Leistungshalbleiterschalter-Chips zu erfassen.

14. Permanentspeichermittel, umfassend eine Software, welche Anweisungen zum Ausführen des Prozesses zur Überwachung einer thermischen Impedanz nach einem der Ansprüche 1 bis 11 umfasst, wenn er durch den Wandler nach Anspruch 12 ausgeführt wird.

**Revendications**

1. Procédé de surveillance d'impédance thermique pour un module de puissance d'un convertisseur de puissance utilisé pour transformer du courant continu en courant alternatif, ou inversement, où le semi-conducteur dissipe une perte asymétrique entre deux demi-cycles d'une fréquence de courant alternatif f du courant alternatif, ledit module de puissance comprenant au moins une puce semi-conductrice (50) fixée à un empilement de couches de matériau pour sa dissipation thermique et/ou ses connexions électriques, le procédé de surveillance d'impédance thermique étant **caractérisé par** les étapes suivantes :

   - l'échantillonnage et la mesure (100) d'un signal relatif à la température de jonction Tj de ladite puce semi-conductrice à une fréquence supérieure à dix fois ladite fréquence de courant alternatif dudit courant alternatif,
   - le calcul (110) d'une durée △t=tTjmax- tTjmin entre un moment tTjmax, où ladite température de jonction de ladite puce semi-conductrice est à une valeur maximale, et un moment tTjmin, où ladite température de jonction est à une valeur minimale, dans une période dudit courant alternatif, et le stockage (120) de ladite durée △t dans une mémoire,
   - la répétition (140, 150) dudit échantillonnage et de ladite mesure dudit signal et dudit calcul de ladite durée à différents moments $t_x = t_0$ à $t_p$ pendant la durée de vie opérationnelle du module de puissance pour fournir une série de durées $\triangle t_{t0}$ à $\triangle t_{tp}$, et la comparaison (130) des valeurs desdites durées $\triangle t_{tp}$ à $\triangle t_{t0}$ pour surveiller une évolution de ladite durée $\triangle t_x$ pour déterminer une évolution de dégradation de l'impédance thermique dudit module de puissance.

2. Procédé de surveillance d'impédance thermique selon la revendication 1, comprenant la moyenne des mesures △t sur des périodes pour réduire un bruit dans les mesures.

3. Procédé de surveillance d'impédance thermique selon la revendication 1 ou 2 comprenant la mesure de ladite fréquence de courant alternatif (200) et le stockage d'un couple de valeurs de durée $\triangle t_{tx}$ et de fréquence de courant alternatif, $f_{fund}$ (220).

4. Procédé de surveillance d'impédance thermique selon la revendication 3, comprenant la modification de ladite fréquence de courant alternatif (260) pendant des périodes de fonctionnement dédiées dudit convertisseur pour fournir plusieurs fréquences de courant alternatif différentes $f_m = f_1, f_2, ..., f_n$ permettant chacune de détecter une impédance thermique d'une couche spécifique dudit empilement, la répétition dudit échantillonnage, de ladite mesure et dudit calcul des durées $\triangle t_{txfm} = \triangle t_{txf1}, \triangle t_{txf2}, ..., \triangle t_{txfn}$ correspondant à de telles fréquences de courant alternatif différentes,

- la répétition (240) dudit échantillonnage et de ladite mesure dudit signal et dudit calcul de ladite durée pendant la durée de vie opérationnelle du module de puissance pour fournir une série de valeurs $\triangle t_{0fm}$ à $\triangle t_{txfm}$ pour chacune desdites fréquences de courant alternatif différentes, et la comparaison desdites valeurs $\triangle t_{tm}$ à $\triangle t_{to}$ à chacune desdites fréquences de courant alternatif pour surveiller une évolution de $\triangle t$ pour chacune desdites fréquences de courant alternatif $f_m = f_1, f_2, ..., f_n$ pour déterminer une évolution de dégradation de l'impédance thermique desdites couches spécifiques.

5. Procédé de surveillance d'impédance thermique selon la revendication 3 ou 4, comprenant la mesure (300) d'une différence de temps $\triangle tmin$ entre deux minima successifs de la température de jonction et le calcul de ladite fréquence de courant alternatif comme $f = 1/\triangle tmin$.

6. Procédé de surveillance d'impédance thermique selon l'une quelconque des revendications précédentes, dans lequel le signal relatif à la température de jonction Tj est un paramètre électrique sensible à la température dudit semi-conducteur.

7. Procédé de surveillance d'impédance thermique selon la revendication 6, dans lequel le signal relatif à la température de jonction Tj est un paramètre électrique sensible à la température non étalonné dudit semi-conducteur.

8. Procédé de surveillance d'impédance thermique selon l'une quelconque des revendications précédentes, dans lequel ladite fréquence de courant alternatif est inférieure à $f_d = \dfrac{D_d}{l_d\,2}$ où $l_{die}$ est l'épaisseur de puce et $D_{die}$ est le coefficient de diffusivité de la puce.

9. Procédé de surveillance d'impédance thermique selon l'une quelconque des revendications précédentes, dans lequel ladite fréquence de courant alternatif est inférieure à 2 kHz.

10. Procédé de surveillance d'impédance thermique selon l'une quelconque des revendications précédentes, dans lequel ladite fréquence de courant alternatif est inférieure à 1 kHz.

11. Procédé de surveillance d'impédance thermique selon l'une quelconque des revendications précédentes, dans lequel ladite fréquence de courant alternatif est la fréquence fondamentale alimentant le convertisseur ou la fréquence de sortie fondamentale $f_{fund}$ du convertisseur.

12. Convertisseur comprenant des moyens de détection (53) sur une puce de commutation de semi-conducteur de puissance dudit convertisseur pour détecter une température de ladite puce de commutation de semi-conducteur de puissance, des moyens de conversion analogique-numérique (54), des moyens d'échantillonnage (55) et un processeur (56) pourvu de moyens de mémoire (57) pour stocker et exécuter un logiciel configuré pour amener le convertisseur à exécuter le procédé de surveillance d'impédance thermique selon l'une quelconque des revendications précédentes.

13. Convertisseur selon la revendication 12 dans lequel lesdits moyens de détection (53) sont conçus pour détecter un paramètre électrique sensible à la température de ladite puce de commutation de semi-conducteur de puissance.

14. Moyens de mémoire permanente comprenant un logiciel comprenant des instructions pour exécuter le processus de surveillance d'impédance thermique selon l'une quelconque des revendications 1 à 11 lorsqu'il est exécuté par le convertisseur selon la revendication 12.

FIG. 1  PRIOR ART

FIG. 2

FIG. 3  PRIOR ART

FIG. 4

FIG. 5

FIG. 6

FIG. 7

FIG. 8

FIG. 9

FIG 10A

FIG. 10B

FIG. 11

FIG. 12

FIG. 13A

MODIFY f — 260

S →
SAMPLING AND MEASURING
S, f — 200

CALCULATING $\Delta t$ @ f — 210

tx=t+dt — 240

STORING
$\Delta t$ @ f — 220

COMPARING
$\Delta t$ @ f — 230

FIG. 13B

END? ◇ No

Yes — 150

END

S →
MEASURING $\Delta t_f$ — 300

FIG. 13C

CALCULATING AC freq
$f=1/\Delta t_f$ — 310

# EP 4 390 349 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **BROECK**. In situ thermal impedance spectroscopy of Power electronic modules for localized degradation identification. *PCIM Europe*, 2019
- International Exhibition and Conference for Power Electronics. *Intelligent Motion, Renewable Energy and Energy Management, 07-09 May 2019 Nuremberg, Germany*, ISBN 978-3-8007-4938-6
- Real-Time, In Situ Degradation Monitoring in Power Semiconductor Converters. **POLOM**. 2019 IEEE Applied Power Electronics Conference and Exposition (APEC) , 17-21 March 2019. IEEE, 17 March 2019
- **XIANG**. Condition Monitoring Power Module Solder Fatigue Using Inverter Harmonic Identification. *IEEE Transactions on Power Electronics*, January 2012, vol. 27 (1), 235-247
- **GERD BUSSE**. Lockin-Thermography: Principles. *NDE-applications and trends, January 2014 Conference: 2014 Quantitative InfraRed Thermography*, January 2014
- **RIGERT**. *Induktions-Lockin-Thermografie : ein neues Verfahren zur zerstörungsfreien Prüfung*, http://dx.doi.org/10.18419/opus-1734